# EUROPEAN PATENT SPECIFICATION

(11) **EP 1 654 395 B1**
(45) Date of publication and mention of the grant of the patent: **14.07.2010**
(21) Application number: 04780608.8
(22) Date of filing: 10.08.2004
(51) Int. Cl.: C23C 14/34, H01J 37/34

(54) **TARGET/BACKING PLATE CONSTRUCTIONS, AND METHODS OF FORMING THEM**
TARGET/TRÄGERPLATTE-KONSTRUKTIONEN UND HERSTELLUNGSVERFAHREN DAFÜR
CONSTRUCTIONS DE PLAQUE CIBLE ET DE CONTREPLAQUE ET PROCEDE DE FABRICATION DE CES CONSTRUCTIONS DE PLAQUE CIBLE ET DE CONTREPLAQUE

(30) Priority: 11.08.2003 US 495070 P
(43) Date of publication of application: 10.05.2006
(60) Divisional application: 10004921.2
(73) Proprietor: Honeywell International Inc., Morristown, NJ 07960 (US)
(72) Inventor: YI, Wuwen, Veradale, WA 99037 (US); RASTOGI, Ravi, Liberty Lake, WA 99019 (US); KIM, Jaeyeon, Liberty Lake, WA 99019 (US); CLARK, Brett, M., Spokane, WA 99206 (US); STROTHERS, Susan, D., Spokane, WA 99217 (US); PINTER, Michael, R., Spokane, WA 99208 (US); KARDOKUS, Janine, K., Liberty Lake, WA 99019 (US)
(74) Representative: Fox-Male, Nicholas Vincent Humbert
(86) International application number: PCT/US2004/025801
(87) International publication number: WO 2005/019493

(56) References cited:
- EP-A- 1 053 810
- WO-A-00/40770
- WO-A-03/106733
- WO-A-2004/076706
- US-A- 5 863 398
- US-A1- 2002 028 538
- US-A1- 2002 068 386

## Description

### TECHNICAL FIELD

The invention pertains to target/backing plate constructions, and also pertains to methods of forming target/backing plate constructions.

### BACKGROUND OF THE INVENTION

Physical vapor deposition (PVD) is frequently utilized for deposition of materials. For instance, semiconductor processing frequently utilizes PVD for deposition of metals and/or other materials over semiconductor substrates.

A typical PVD operation utilizes a target comprising a desired material. The target is provided within a chamber of an appropriate apparatus. The target is typically bonded to a backing plate, and the backing plate is utilized to retain the target in a desired orientation within the apparatus. A substrate is provided in a location of the chamber spaced from the target. Desired material of the target is then sputtered or otherwise dislodged from the target, whereupon the desired material deposits on the substrate.

Various difficulties can be encountered in bonding targets to backing plates. For instance, if the temperature utilized to bond the target to the backing plate is too high, grain sizes within the target can grow excessively. Generally, targets with smaller grain sizes are better for PVD processes than are targets containing larger grain sizes. Another problem which can occur in bonding targets to backing plates is that if the target/backing plate bond is not sufficiently strong, the bond can break under the repeated thermal stress associated with PVD processes. Particularly strong bonds can be desired for so-called ionized PVD (I-PVD) processes. The high powers typically utilized in I-PVD applications cause high gas temperatures (rarefication of the ionizing gas, thermalization of the sputtered metal species), which in turn can cause the temperature of the target to rise. It can be desired that target/backing plate assemblies have a bond strength between the target and backing plate of at least about 5.84kg m⁻² [20,000 pounds per square inch (i.e., 20 ksi)] in order to withstand the stresses associated with the high power levels of I-PVD processing.

It is desired to develop target/backing plate assemblies having desired small grain sizes within the target, while also having desired high bond strengths.

### SUMMARY OF THE INVENTION

The present invention provides a target/backing plate construction as defined in Claim 1.

The construction may include the features of any one or more of dependent Claims 2 to 5.

The present invention also provides a method as defined in Claim 6.

The present invention also provides a method as defined in Claim 7.

The method may include the features of Claim 8.

In one aspect, the invention includes a target/backing plate construction. The construction includes a copper-containing target having an average grain size of less than 80 microns. The construction has a bond strength from the target to the backing plate of at least about 5.84 kg m⁻² (20 ksi).

In one aspect, the invention includes a target/backing plate construction. The construction includes a copper-containing target, a backing plate, and an interlayer between the target and backing plate. The backing plate comprises at least about 0.1 weight % of each of copper, chromium, nickel and silicon. In particular aspects, the backing plate consists essentially of copper, chromium, nickel and silicon with the nickel being present to from about 2 weight % to about 3 weight %; the silicon being present to from about 0.4 weight % to about 0.8 weight %; and the chromium being present to from about 0.1 weight % to about 0.8 weight %. The interlayer can comprise one or more of silver, copper, nickel, tin and indium. In particular aspects, the bond strength from the target to the backing plate through the interlayer is at least about 5.84 kg m⁻² (20 ksi), while the average grain size within the target is less than 80 microns, and in some aspects less than or equal to about 45 microns.

In one aspect, the invention includes a target/backing plate construction containing a target predominately comprising (in other words, comprising more than 50%, by weight) aluminum, a backing plate, and an interlayer predominately comprising nickel or titanium between the target and the backing plate.

In one aspect, the invention includes a method of forming a target/backing plate construction. A target is provided. The target is of a first composition and has a first bonding surface. A backing plate is provided. The backing plate is of a second composition different from the first composition and has a second bonding surface. An interlayer composition is formed on one or both of the first and second bonding surfaces. The interlayer composition predominately comprises a material soluble in one or both of the first and second compositions. The target is bonded to the backing plate through the interlayer composition.

### BRIEF DESCRIPTION OF THE DRAWINGS

Fig. 1 is a diagrammatic, cross-sectional view of an exemplary target/backing plate construction of the present invention.

Fig. 2 is a top view of the Fig. 1 construction, with the cross-section of Fig. 1 extending along the line 1-1 of Fig. 2.

### DETAILED DESCRIPTION OF THE PREFERRED EMBODIMENTS

One aspect of the present invention pertains to utilization of alloys or other compositions comprising copper, chromium, nickel and silicon as backing plate materials (i.e., CuCrNiSi materials). An exemplary material can comprise from about 2% to about 3% nickel, from about 0.4% to about 0.8% silicon, from about 0.1% to about 0.8% chromium, and the balance copper (with the percentages listed as weight percent). Such material has a tensile strength of about 700 MPa, a yield strength of about 630 MPa, a hardness greater than 158 HB, an average coefficient of thermal expansion of about 17.3 µm/m.C, and an electrical conductivity at 20°C of about 40% IACS. Such backing plate material can be referred to as C18000. The backing plate material can be utilized in combination with high purity copper targets, such as, for example, targets having a copper purity of greater than 99.9% (i.e., 3N), by weight percent, and in particular applications copper targets having greater than 99.995% (i.e., 4N5) copper, such as, for example, targets having greater than or equal to 99.9999% (i.e., 6N) copper.

In the past, copper targets have typically been bonded to CuCr backing plates (with the backing plates typically comprising from about 0.6 weight percent to about 1.2 weight percent chromium, with the balance of the composition being copper). An advantage of CuCrNiSi backing plate constructions relative to the previously-utilized CuCr constructions can be that CuCrNiSi can have a more suitable conductivity for particular applications, and another advantage is that CuCrNiSi can have a more suitable strength for particular applications. Specifically, CuCrNiSi can have a higher strength and lower conductivity than CuCr.

Difficulties in utilizing CuCrNiSi occur in attempting to bond high-purity copper targets to the backing plates. Specifically, it is difficult to achieve a bond strength of 5.84 kg m⁻² (20 ksi) or greater without utilizing conditions which grow a grain size within a copper target to an unacceptable size (with a typical unacceptable size being a grain size greater than or equal to 80 microns).

In accordance with an aspect of the present invention, an interlayer is provided between a high-purity copper target and a CuCrNiSi backing plate. The interlayer can comprise, consist essentially of, or consist of, for example, one or more of silver, copper, nickel, tin and indium. Such materials are preferred for the interlayer because there can be good diffusion between the materials and the backing plate and target.

A target is provided which comprises a first composition, and a backing plate is provided which comprises a second composition different from the first composition. The target has a bonding surface (which can be referred to as a first bonding surface) and the backing plate has a bonding surface (which can be referred to as a second bonding surface). The interlayer composition is provided on the bonding surface of the target and/or the bonding surface of the backing plate, and subsequently the target and backing plate are subjected to conditions causing bonding of the target and backing plate through the interlayer composition. It can be preferred that the interlayer composition be formed at least on the backing plate bonding surface in applications in which the backing plate comprises CuCrNiSi, in that the backing plate can have an oxide surface which interferes with bonding unless the surface is disrupted prior to bonding. The provision of the interlayer composition on the surface can disrupt the oxide surface. The oxide may occur through oxidation of silicon associated with the CuCrNiSi. Regardless of the cause of the oxide, the oxide can be disrupted by a chemical treatment in addition to, or alternatively to, formation of the interlayer composition on the backing plate. An exemplary chemical treatment is to treat a bonding surface of the backing plate with either hydrofluoric acid alone, or a combination of hydrofluoric acid and nitric acid, to remove oxide from the surface. Such treatment can also remove silicon from the bonding surface, which can be desired in particular applications. An exemplary treatment process can comprise the following seven steps:
1) a bonding surface of the backing plate is exposed to a basic solution (with a suitable basic solution being a sodium hydroxide solution formed from Metex T-103^{™});
2) the bonding surface is rinsed with deionized water;
3) the bonding surface is treated with a solution comprising nitric acid and hydrofluoric acid (such as, for example, a solution comprising about 43% nitric acid and about 4.9% hydrofluoric acid (v/v));
4) the bonding surface is rinsed with deionized water;
5) the bonding surface is treated with a solution comprising sulfuric acid (such as, for example, a solution comprising about 2.8% sulfuric acid (v/v));
6) the bonding surface is rinsed with deionized water; and
7) the backing plate is dried using high pressure air and then promptly vacuum bagged to avoid surface oxidation.
The treatment with the hydroxide (step 1) can occur for about 30 seconds, the treatment with the hydrofluoric acid/nitric acid mixture (step 3) can occur for about 10 seconds, and the treatment with the sulfuric acid (step 5) can occur for about 30 seconds, in typical applications.

The chemical treatment described above can be utilized with or without the interlayer composition described herein, but typically would be utilized as a pretreatment in conjunction with applications that also utilized the interlayer composition. Similarly, the interlayer composition can be utilized with or without the chemical treatment described herein.

The interlayer composition can be applied to the backing plate bonding surface and/or target bonding surface utilizing any suitable method, including, for example, ion plating, electroplating, electroless methodology, etc.

Once the interlayer composition has been applied to one or both of the target bonding surface and the backing plate bonding surface, the backing plate is bonded to the target utilizing, for example, hot isostatic pressing (HIP) at a temperature of from about 250°C to about 450°C, and the interlayer composition becomes an interlayer between the target and backing plate. In applications in which the backing plate comprises, consists essentially of, or consists of CuCrNiSi; the interlayer comprises, consists essentially of, or consists of silver; and the target comprises high-purity copper, the bond strength between the target and backing plate can be at least about 20,000 Ibs per square inch while an average grain size within the target remains less than 80 microns, and in some aspects while substantially all of the grains within the target have a maximum grain size of less than about 80 microns. In one exemplary application, Cu is ion plated on bonding surfaces of both a 99.9999% Cu target and a CuCrNiSi backing plate prior to diffusion bonding. The ion plated layers are about 5 microns thick on the target and backing plate. The target and backing plate are diffusion bonded at 400°C by HIP. The bond strength is about 5.96 kg m⁻² (20.4 ksi) and the average target grain size is about 49 microns. When an identical target is bonded to an identical backing plate with HIP at 450°C but without an interlayer, the bond strength is about 3.65 kg m⁻² (12.5 ksi) and the average target grain size is about 210 microns.

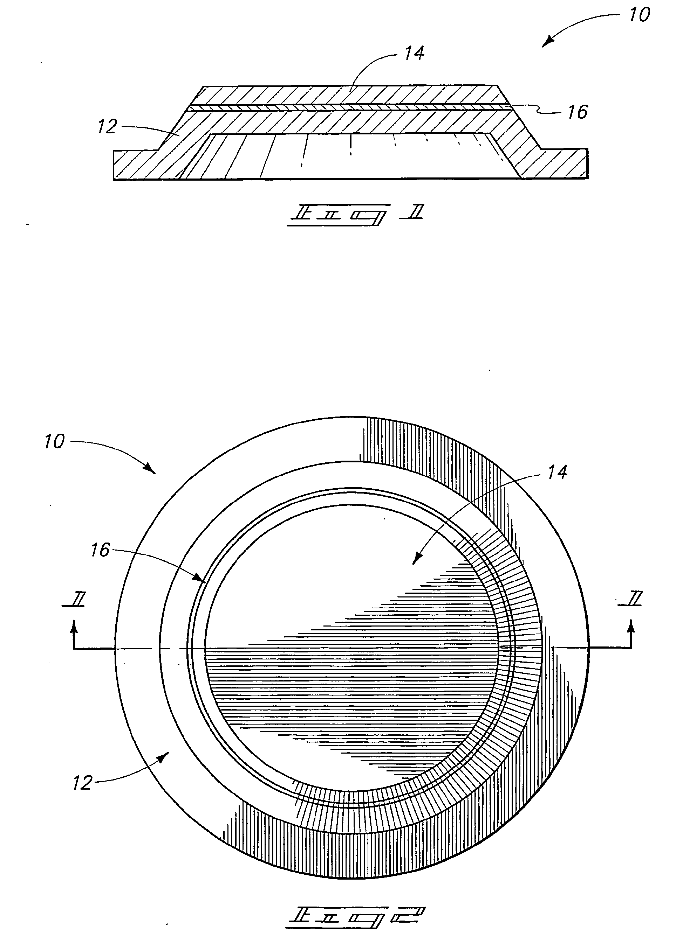

An exemplary target/backing plate construction 10 which can be formed in accordance with methodology of the present invention is described with reference to Figs. 1 and 2. The construction comprises a backing plate 12, a target 14, and an interlayer 16 between the target and backing plate (the interlayer is specifically at an interface between a bonding surface of the target and a bonding surface of the backing plate). The backing plate can, in particular aspects, comprise CuCrNiSi, the target can comprise high-purity copper, and the interlayer can comprise one or both of silver and copper. The interlayer will typically have a thickness of from about 0.1 microns to about 20 microns. Construction 10 is shown in an exemplary shape. It is to be understood that the methodology of the present invention can be utilized to form numerous target/backing plate constructions, including, but not limited to, the shown shape of construction 10. Although the interlayer is shown as a single homogeneous composition, it is to be understood that the interlayer can, in some aspects, comprise a stack of differing compositions.

The methodology of the present invention can be particularly useful for bonding high-purity copper targets to backing plates comprising CuCrNiSi in order to obtain high strength bonds while retaining small grain sizes in the high-purity copper material. However, It is to be understood that the invention can be applied to other target/backing plate compositions. For instance, the target can comprise, consist essentially of, or consist of one or more of aluminum, tantalum, titanium and copper, or can comprise any other composition suitable for bonding through an appropriate interlayer. The backing plate can comprise one or more of copper, chromium, nickel and silicon, and in particular applications can be a backing plate of Cu and Cr. The backing plate is not limited to the compositions described above, and can comprise any suitable composition which can be appropriately bonded to a suitable target utilizing the methodology described herein. In choosing an appropriate interlayer to utilize between a particular target and a particular backing plate, it can be desired to choose a material soluble in either of, and preferably both of, the target and backing plate compositions.
If, for example, a target predominately comprising aluminum (by weight) is utilized, it can be desired to utilize an interlayer predominately comprising nickel or titanium (by weight). In some aspects, the target can consist essentially or consist of aluminum, and the interlayer can consist essentially of or consist of nickel or titanium.

Although HIP is described above for forming a bond between a target and backing plate, it is to be understood that methodology of the present invention can be utilized with other methods of bonding targets to backing plates. For instance, explosion bonding techniques can be utilized to bond Cu-containing targets to CuCrNiSi backing plates. An exemplary explosion bonding technique forms an approximate bond strength of at least about 13.14 kg m⁻² (45 ksi) (and in particular aspects about 13.12 kg m⁻² [47 ksi], between a 99.9999% Cu target and a CuCrSiNi backing plate, and maintains a maximum target grain size of from about 38 microns to about 45 microns, with the average target grain size being less than or equal to about 45 microns (typically less than or equal to about 41 microns). The explosion bonding technique can be utilized without a chemical surface treatment of the backing plate, and without an interlayer between the backing plate and target.

## Claims

1. A target/backing plate construction, comprising:
a copper-containing target;
a backing plate comprising at least about 0.1 weight percent of each of copper, chromium, nickel and silicon;
an interlayer between the target and backing plate, the interlayer comprising a different composition than both the target and the backing plate;
an average grain size within the target of less than 80 microns; and
a bond strength between the target and backing plate of at least about 5.84 Kg m⁻² (20 ksi).

2. The construction of Claim 1 wherein the interlayer comprises one or more of silver, copper, nickel, tin and indium.

3. The construction of Claim 1 wherein the interlayer consists of one or more of silver, copper, nickel, tin and indium.

4. The construction of Claim 1 wherein the average grain size within the target is less than or equal to about 45 microns, and comprising a bond strength from the target to the backing plate through the interlayer of at least about 13.14 Kg m⁻² (45 ksi).

5. The construction of Claim 1 wherein the backing plate consists of the copper, chromium, nickel and silicon, and comprises:
from about 2 weight percent to about 3 weight percent of the nickel;
from about 0.4 weight percent to about 0.8 weight percent of the silicon; and
from about 0.1 weight percent to about 0.8 weight percent of the chromium.

6. A method of forming a target/backing plate construction, comprising:
providing a target, the target being of a first composition and having a first bonding surface;
providing a backing plate, the backing plate being of a second composition different from the first composition and having a second bonding surface;
forming an interlayer composition on one or both of the first and second bonding surfaces, the interlayer composition predominately comprising a material soluable in one or both of the first and second compositions; and
bonding the target to the backing plate through the interlayer composition, the interlayer composition being between the bonded target and backing plate as an interlayer; and
wherein the interlayer composition is formed on both the first and second bonding surfaces prior to bonding target to the backing plate, wherein the target comprises copper having a purity of greater 99.995%, wherein the backing plate comprises CuCrNiSi, and wherein the forming the interlayer composition comprises ion plating copper onto both the first and second bonding surfaces.

7. A method of forming a target/backing plate constructions, comprising:
providing a target, the target being of a first composition and having a first bonding surface;
providing a backing plate, the backing plate being of a second composition different from the first composition and having a second bonding surface;
forming an interlayer composition on one or both of the first and second bonding surfaces, the interlayer composition predominately comprising a material soluble in one or both of the first and second compositions; and
bonding the target to the backing plate through the interlayer composition, the interlayer composition being between the bonded target and backing plate as an interlayer; and
wherein the backing plate comprises CuCrNiSi and wherein the interlayer composition is formed on the second bonding surface prior to bonding the target to the backing plate.

8. The method of Claim 7 wherein an oxide is over the second bonding surface prior to forming the interlayer composition on the second bonding surface, and further comprising subjecting the second bonding surface to chemical treatment to disrupt the oxide prior to forming the interlayer composition on the second bonding surface.

## Patentansprüche

1. Target/Trägerplatte-Konstruktion, umfassend:
ein kupferhaltiges Target;
eine Trägerplatte, die mindestens etwa 0,1 Gewichtsprozent von jedem von Kupfer, Chrom, Nickel und Silizium umfaßt;
eine Zwischenschicht zwischen dem Target und der Trägerplatte, wobei die Zwischenschicht eine andere Zusammensetzung als sowohl das Target als auch die Trägerplatte umfaßt;
eine mittlere Korngröße innerhalb des Targets von weniger als 80 Mikrometern und
eine Bindefestigkeit zwischen dem Target und der Trägerplatte von mindestens etwa 5,84 kg m⁻² (20 ksi).

2. Konstruktion nach Anspruch 1, wobei die Zwischenschicht eines oder mehrere von Silber, Kupfer, Nickel, Zinn und Indium umfaßt.

3. Konstruktion nach Anspruch 1, wobei die Zwischenschicht aus einem oder mehreren von Silber, Kupfer, Nickel, Zinn und Indium besteht.

4. Konstruktion nach Anspruch 1, wobei die mittlere Korngröße innerhalb des Target kleiner oder gleich etwa 45 Mikrometer beträgt, und umfassend eine Bindefestigkeit von dem Target zu der Trägerplatte durch die Zwischenschicht von mindestens etwa 13,14 kg m⁻² (45 ksi).

5. Konstruktion nach Anspruch 1, wobei die Trägerplatte aus Kupfer, Chrom, Nickel und Silizium besteht und folgendes umfaßt:
von etwa 2 Gewichtsprozent bis etwa 3 Gewichtsprozent Nickel;
von etwa 0,4 Gewichtsprozent bis etwa 0,8 Gewichtsprozent Silizium und
von etwa 0,1 Gewichtsprozent bis etwa 0,8 Gewichtsprozent Chrom.

6. Verfahren zum Ausbilden einer Target/Trägerplatte-Konstruktion, umfassend:
Bereitstellen eines Targets, wobei das Target eine erste Zusammensetzung und eine erste Verbindungsoberfläche aufweist;
Bereitstellen einer Trägerplatte, wobei die Trägerplatte eine von der ersten Zusammensetzung verschiedene zweite Zusammensetzung und eine zweite Verbindungsoberfläche aufweist;
Ausbilden einer Zwischenschichtzusammensetzung auf einer oder beiden der ersten und zweiten Verbindungsoberfläche, wobei die Zwischenschichtzusammensetzung vorwiegend ein Material umfaßt, das in einer oder beiden der ersten und zweiten Zusammensetzung löslich ist; und
Verbinden des Targets mit der Trägerplatte durch die Zwischenschichtzusammensetzung, wobei die zwischenschichtzusammensetzung zwischen dem verbundenen Target und der Trägerplatte als eine zwischenschicht vorliegt; und
wobei die zwischenschichtzusammensetzung sowohl auf der ersten als auch zweiten Verbindungsoberfläche vor dem Verbinden des Targets mit der Trägerplatte ausgebildet wird, wobei das Target Kupfer mit einer Reinheit von größer als 99,995% umfaßt, wobei die Trägerplatte CuCrNiSi umfaßt und wobei das Ausbilden der Zwischenschichtzusammensetzung Ioenplattieren von Kupfer sowohl auf die erste als auch zweite Verbindungsoberfläche umfaßt.

7. Verfahren zum Ausbilden einer Target/Trägerplatte-Konstruktion, umfassend:
Bereitstellen eines Targets, wobei das Target eine erste Zusammensetzung und eine erste Verbindungsoberfläche aufweist;
Bereitstellen einer Trägerplatte, wobei die Trägerplatte eine von der ersten Zusammensetzung verschiedene zweite Zusammensetzung und eine zweite Verbindungsoberfläche aufweist;
Ausbilden einer Zwischenschichtzusammensetzung auf einer oder beiden der ersten und zweiten verbindungsoberfläche, wobei die Zwischenschichtzusammensetzung vorwiegend ein Material umfaßt, das in einer oder beiden der ersten und zweiten Zusammensetzung löslich ist; und
Verbinden des Target mit der Trägerplatte durch die Zwischenschichtzusammensetzung, wobei die Zwischenschichtzusammensetzung zwischen dem verbundenen Target und der Trägerplatte als eine Zwischenschicht vorliegt; und
wobei die Trägerplatte CuCrNiSi umfaßt und wobei die Zwischenschichtzusammensetzung auf der zweiten Verbindungsoberfläche vor dem Verbinden des Targets mit der Trägerplatte ausgebildet wird.

8. Verfahren nach Anspruch 7, wobei sich ein Oxid über der zweiten Verbindungsoberfläche vor dem Ausbilden der Zwischenschichtzusammensetzung auf der zweiten Verbindungsoberfläche befindet, und weiterhin umfassend, die zweite Verbindungsoberfläche einer chemischen Behandlung zu unterziehen, um das Oxid vor dem Ausbilden der Zwischenschichtzusammensetzung auf der zweiten Verbindungsoberfläche zu unterbrechen.

## Revendications

1. Construction cible/plaque d'appui, comprenant :
une cible contenant du cuivre ;
une plaque d'appui comprenant au moins environ 0,1 pour cent en poids de chacun des éléments cuivre, chrome, nickel et silicium ;
une couche intermédiaire entre la cible et la plaque d'appui, la couche intermédiaire ayant une composition différente à la fois de celle de la cible et de celle de la plaque d'appui ;
une granulométrie moyenne à l'intérieur de la cible inférieure à 80 micromètres ; et
une résistance d'adhésion entre la cible et la plaque d'appui d'au moins environ 5,84 kg.m⁻² (20 ksi).

2. Construction selon la revendication 1 dans laquelle la couche intermédiaire comprend l'un ou plusieurs des éléments argent, cuivre, nickel, étain et indium.

3. Construction selon la revendication 1 dans laquelle la couche intermédiaire consiste en l'un ou plusieurs des éléments argent, cuivre, nickel, étain et indium.

4. Construction selon la revendication 1 dans laquelle la granulométrie moyenne à l'intérieur de la cible est inférieure ou égale à environ 45 micromètres, et ayant une résistance d'adhésion entre la cible et la plaque d'appui par la couche intermédiaire d'au moins environ 13,14 kg.m⁻² (45 ksi).

5. Construction selon la revendication 1 dans laquelle la plaque d'appui consiste en les éléments cuivre, chrome, nickel et silicium, et comprend :
environ 2 pour cent en poids à environ 3 pour cent en poids de nickel ;
environ 0,4 pour cent en poids à environ 0,8 pour cent en poids de silicium ; et
environ 0,1 pour cent en poids à environ 0,8 pour cent en poids de chrome.

6. Procédé de formation d'une construction cible/plaque d'appui, comprenant :
l'obtention d'une cible, la cible étant d'une première composition et ayant une première surface d'assemblage ;
l'obtention d'une plaque d'appui, la plaque d'appui étant d'une deuxième composition différente de la première composition et ayant une deuxième surface d'assemblage ;
la formation d'une composition de couche intermédiaire sur la première et/ou la deuxième surface d'assemblage, la composition de couche intermédiaire comprenant principalement un matériau soluble dans la première et/ou la deuxième composition ; et
l'assemblage de la cible à la plaque d'appui par la composition de couche intermédiaire, la composition de couche intermédiaire se situant entre la cible et la plaque d'appui assemblées sous la forme d'une couche intermédiaire ; et
dans lequel la composition de couche intermédiaire est formée sur la première et la deuxième surface d'assemblage avant d'assembler la cible à la plaque d'appui, dans lequel la cible comprend du cuivre ayant une pureté supérieure à 99,995 %, dans lequel la plaque d'appui comprend du CuCrNiSi, et dans lequel la formation de la composition de couche intermédiaire comprend le placage ionique de cuivre sur la première et la deuxième surface d'assemblage.

7. Procédé de formation d'une construction cible/plaque d'appui, comprenant :
l'obtention d'une cible, la cible étant d'une première composition et ayant une première surface d'assemblage ;
l'obtention d'une plaque d'appui, la plaque d'appui étant d'une deuxième composition différente de la première composition et ayant une deuxième surface d'assemblage ;
la formation d'une composition de couche intermédiaire sur la première et/ou la deuxième surface d'assemblage, la composition de couche intermédiaire comprenant principalement un matériau soluble dans la première et/ou la deuxième composition ; et
l'assemblage de la cible à la plaque d'appui par la composition de couche intermédiaire, la composition de couche intermédiaire se situant entre la cible et la plaque d'appui assemblées sous la forme d'une couche intermédiaire ; et
dans lequel la plaque d'appui comprend du CuCrNiSi, et dans lequel la composition de couche intermédiaire est formée sur la deuxième surface d'assemblage avant d'assembler la cible à la plaque d'appui.

8. Procédé selon la revendication 7 dans lequel un oxyde recouvre la deuxième surface d'assemblage avant de former la composition de couche intermédiaire sur la deuxième surface d'assemblage, et comprenant en outre la soumission de la deuxième surface d'assemblage à un traitement chimique pour dissocier l'oxyde avant de former la composition de couche intermédiaire sur la deuxième surface d'assemblage.
